Europäisches Patentamt

(19) European Patent Office

Office européen des brevets

(11) Publication number: **0 177 148**

**A2**

(12) # EUROPEAN PATENT APPLICATION

(21) Application number: **85305833.7**

(22) Date of filing: **16.08.85**

(51) Int. Cl.⁴: **H 02 M 7/538**

(30) Priority: **29.08.84 US 645240**

(43) Date of publication of application:
**09.04.86 Bulletin 86/15**

(84) Designated Contracting States:
**BE DE FR GB NL SE**

(71) Applicant: BURROUGHS CORPORATION (a Delaware corporation)
Burroughs Place
Detroit Michigan 48232(US)

(72) Inventor: Weiss, Ernest
1852 N.W. 82nd Ave.
Coral Springs Florida 33065(US)

(74) Representative: Kirby, Harold Douglas Benson et al,
G.F. Redfern & Company Marlborough Lodge 14
Farncombe Road
Worthing West Sussex BN11 2BT(GB)

(54) **Power supplies using mosfet devices.**

(57) A power supply for driving multi-electrode semiconductor power devices such as field effect transistors (FETs) including an integrated circuit module providing control signals which are coupled to the primary winding of a transformer which has two secondary windings. Each secondary winding is coupled to a drive circuit which is coupled to an FET. The FETs provide output voltages across an output transformer. Each drive circuit includes series-connected NPN and PNP transistors, each having a capacitor in its current flow circuit so that, as each transistor turns on, current flows from the capacitor into the FET to turn it on, the capacitor being recharged as the FET conducts. The combination of the transistors and capacitor acts like a power supply for the FET.

FIG.1.

-1-

# POWER SUPPLIES USING
## MOSFET DEVICES

BACKGROUND OF THE INVENTION

A relatively new semiconductor device is a field effect transistor known as a MOSFET. The MOSFET is a desirable circuit component because it can simplify circuitry while optimizing performance and reducing components.

One use for power MOSFET devices is in power supplies such as full and half-bridge inverters. In such circuits, for example, the half-bridge inverters, an integrated control circuit is coupled through a transformer to drive two MOSFETs which provide the desired output. The integrated circuit contains all of the low level functions necessary for the control of the power supply.

To obtain efficient and well-controlled operation from MOSFET devices, they should turn on and off very rapidly, for example, in 20 to 100 nanoseconds. However, considerable current is required to overcome the various inter-electrode capacitances of MOSFETs, in which, for example, gate capacitance can range from 750 to 3000 PF. In a half-bridge circuit, there are two MOSFET gates to be turned on (four gates in a full bridge), and the gate potential must be raised to at least 10 to 12 volts D.C. to guarantee a full on condition. The current necessary ( 1 ampere) for good drive is not available from a typical integrated circuit.

To circumvent this drive problem, two alternate schemes are available, and, in these schemes, auxiliary power supplies are provided, either in the primary of the coupling transformer or in the secondary where two are normally provided, one for each MOSFET of a half-bridge. The preferred drive circuit utilizes auxiliary power supplies in the secondary of the transformer, and it can be seen that this is a disadvantage in this type of circuit since two isolated power supplies are required in a half-bridge and three isolated power supplies are required for a full bridge inverter.

The present invention provides a power supply circuit using MOSFET devices in which auxiliary power supplies are not required for optimum operation and for achieving fast turn-on and turn-off of the MOSFETs.

DESCRIPTION OF THE DRAWINGS

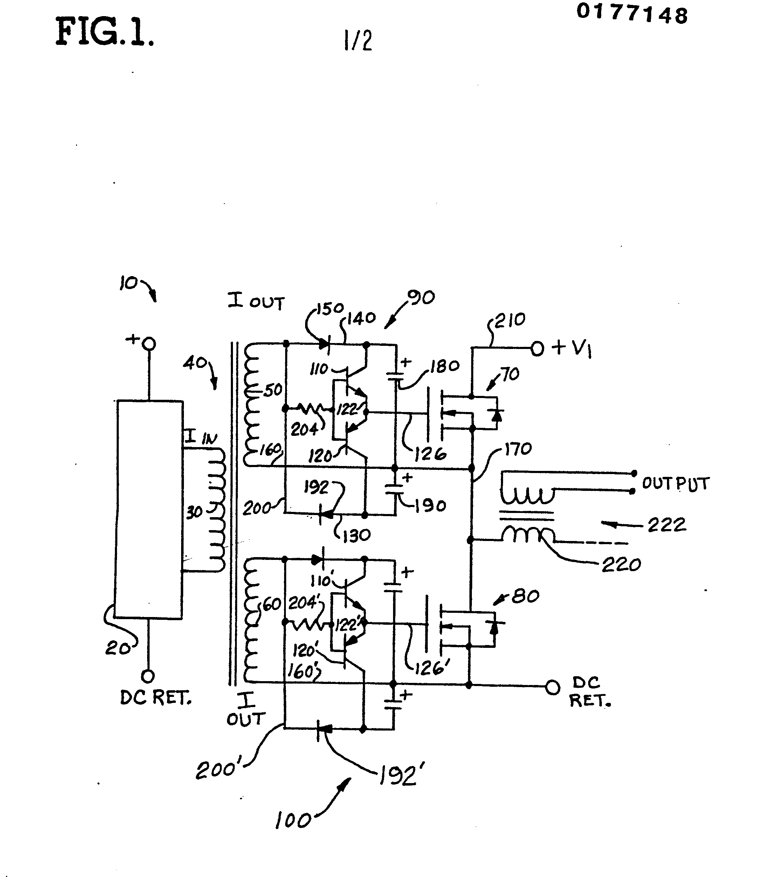

Fig. 1 is a schematic representation of the circuit of the invention; and

Fig. 2 shows come of the current and voltage signals which appear in the circuit of Fig. 1.

DESCRIPTION OF THE INVENTION

The principles of the invention are described with respect to a half-bridge inverter circuit 10 embodying the invention. The circuit 10 includes an integrated circuit driver 20 which contains all of the low level functions necessary for the control of a power supply. A typical module 20 is the SG 3526 made by Silicon General Co. The output of driver 20 is coupled across the primary winding 30 of a transformer 40 having two identical secondary windings 50 and 60. The transformer provides D.C. isolation between driver 20, which is normally at the same potential as the output of the power supply, and the high voltage potential required by the power stage of the inverter, which is normally obtained directly from the power mains without isolation.

The circuit 10 also includes as its output devices, two P-channel MOSFET field effect transistor devices 70 and 80 whose electrodes, source, drain, and gate are represented in conventional fashion.

Coupled between transformer winding 50 and MOSFET 70 is a driver circuit 90, and between transformer winding 60 and MOSFET 80 is a driver circuit 100. The circuits 90 and 100 act like supplies and drivers for their MOSFETs. Circuit 90 includes an NPN transistor 110 connected in series with a PNP transistor 120, with their emitters connected together by lead 122 and to the gate of MOSFET 70 by lead 126. The collector of PNP transistor 120 is connected to lead 130, and the collector of NPN transistor 110 is connected to lead 140. Lead 140 is connected through a diode 150, oriented as shown, to the upper dotted end of secondary winding 50, the lower end of which is connected by lead 160 to lead 170 which is connected to the drain of MOSFET 70 and the source of MOSFET 80. The collector of transistor 110 is connected through capacitor 180 to lead 160, and this junction point is connected through capacitor 190 to lead 130 and to the collector of transistor 120 and through diode 192, oriented as shown, by lead 200 to lead 150. The lead 200 is coupled by resistor 204 to the interconnected base electrodes of transistors 110 and 120.

The source of MOSFET 70 is connected by lead 210 to a positive power supply V1.

The second circuit 100 for MOSFET 80 is identical to the circuit 90 for MOSFET 70, and the same parts carry the same reference numerals with a prime marking. However, the lower end of secondary winding 70 is the dotted end and is coupled by lead 160' to the drain of MOSFET 80 and to the D.C. return of the circuit 10.

Lead 170 is connected to the primary winding 220 of an output transformer.

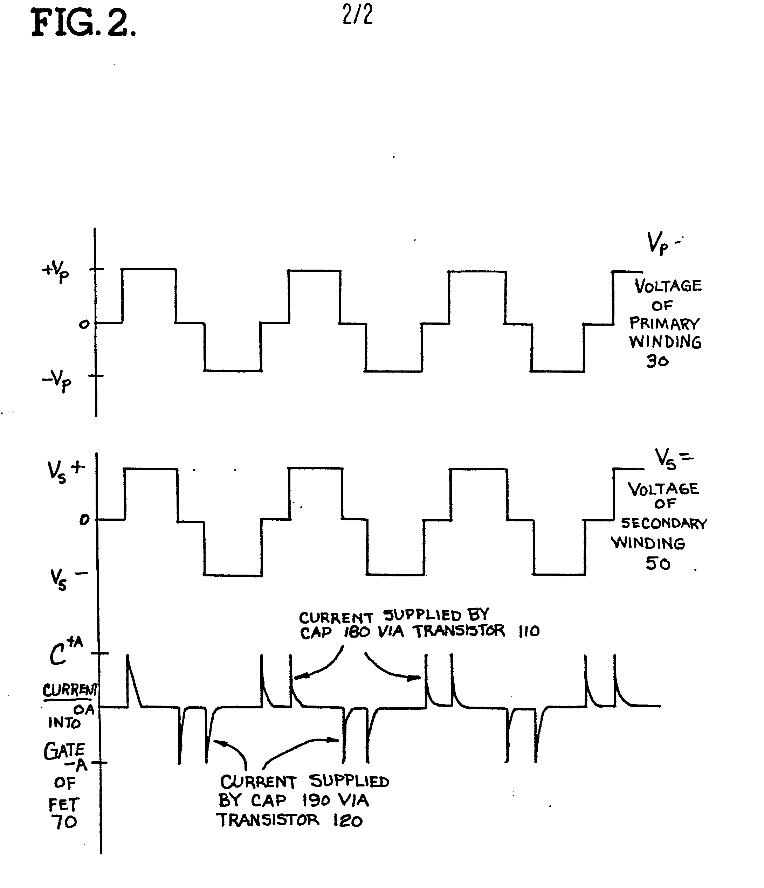

In operation of the circuit 10, assume that capacitors 180 and 190 are charged and the driver 20 generates a waveform or signal (A in Fig. 2) including positive and negative rectangular pulses. Secondary winding 50 reproduces this waveform (B in Fig. 2) and the positive and negative pulses in the waveform. During the positive-going portion of the waveform B, the base electrode of transistor 110 is forward-biased, and current flows from capacitor 180 through transistor 110 and lead 126 to the base of MOSFET 70 which is driven positive and turns on and generates a positive pulse across the primary winding 220 of transformer 222. At the same time, diode 150 conducts and charges capacitor 180 essentially to the peak of the positive pulse. Since the "on" time of the MOSFET is larger than the time of the positive-going portion of waveform A, capacitor 180 is fully charged. On the negative-going portion of waveform A, when the pulse reaches zero potential, diode 150 is reverse-biased, transistor 110 is turned off, and the charge holds on capacitor 180. On the negative-going portion of the waveform A, the events described above are repeated for transistor 120, and, in this case, capacitor 190 is negatively charged. In this case, MOSFET 70 generates a negative pulse across transformer winding 220. The second and all subsequent positive-going signals control transistor 110 as an emitter providing the necessary charge and discharge currents for the gate of MOSFET 70. The same is true for transistor 120 and its MOSFET 80.

The operation of the circuit 100 is identical but 180° out of phase with that of circuit 90.

Since the total power dissipation in the MOSFET gate circuits is negligible, operating current of driver 20 is well within its rating, and the drive transformer current-handling requirements are reduced significantly.

D.C. drive transistor configurations may vary significantly. Small signal MOSFETS may be substituted in lieu of Bipolars, transistors 110 and 120, and single polar supplies may be used instead of both positive and negative ones, but they have less noise immunity.

The above invention as described will also provide good drive signals to any power MOSFET driver, whether N or P channel.

The primary advantages of the invention are (1) that separate power supplies are not required for the output field-effect transistors, and (2) the circuit can generate relatively high current pulses for the output FETs although the input driver or control module is a low power level source.

What is claimed is:

1.      A power supply for driving multi-electrode semiconductor power devices including a circuit module providing control signals and coupled to the primary winding of a transformer having a second winding which reproduces a signal which is applied across the primary winding; a first multi-electrode semiconductor device coupled to an output transformer; and a drive circuit coupled to said first semiconductor device; said drive circuit including a capacitor which is charged and, when charged, operates as a power supply for operating said first semiconductor device; said drive circuit including switch means operable by an input signal from said circuit module to provide current flow in a path including said capacitor to said first semiconductor device which is turned on thereby and generates an output pulse.

2.      The power supply defined in Claim 1 and including, in said drive circuit, a switching transistor coupled between said first secondary winding and said first semiconductor device and being in a current flow path with said capacitor, said switching transistor being turned on by a signal generated by said circuit module and itself then turning on said first semiconductor device.

3.        The power supply defined in Claim 1 wherein said drive circuit includes an NPN transistor and a PNP transistor having their emitters connected together and to the gate of said first semiconductor device; a capacitor associated with each transistor and connected so that, at one time, one transistor and its capacitor are in a current flow path which turns on said first semiconductor device, and, at another time, the other transistor and its capacitor are in a current flow path which turns on said first semiconductor device.

4.        The power supply defined in Claim 2 wherein said first semiconductor device is a field effect transistor having gate, source, and drain electrodes.

5.        The power supply defined in Claim 2 wherein said first semiconductor device is a field effect transistor having gate, source, and drain electrodes, and said switching transistor and said current flow path run to the gate electrode of said first semiconductor device.

6.          A power supply for driving   multi-electrode semiconductor power devices including

a circuit module providing control signals and coupled to the primary winding of a transformer having a first secondary winding and a second secondary winding, said first secondary winding reproducing a signal which is applied across the primary winding, and said second secondary winding producing the same signal but $180^{o}$ out of phase;

a first multi-electrode semiconductor device coupled to an output transformer;

a first drive circuit coupled between said first secondary winding and said first semiconductor device;

said first drive circuit including a first capacitor which, when charged, operates as a power supply for operating said first semiconductor device;

said first drive circuit including switch means operable by an input signal from said circuit module to provide current flow in a path including said first capacitor to said first semiconductor device which is turned on thereby and generates an output pulse;

a second multi-electrode semiconductor device coupled to an output transformer; and

a second drive circuit coupled between said second secondary winding and said second semiconductor device;

said second drive circuit including a second capacitor which, when charged, operates as a power supply for operating said second semiconductor device;

said second drive circuit including switch means operable by an input signal from said circuit module to provide current flow in a path including said second capacitor to said second semiconductor device which is turned on thereby and generates an output pulse.

7. The power supply defined in Claim 6 wherein each said first and second drive circuits includes an NPN transistor and a PNP transistor connected across said secondary winding having their emitters connected together and to the gate of said first semiconductor device;

a capacitor associated with each transistor and connected so that, at one time, one transistor and its capacitor are in a current flow path which turns on said first semiconductor device, and, at another time, the other transistor and its capacitor are in a current flow path which turns on said first semiconductor device.

FIG.1.

1/2

0177148

0177148

FIG.2.

$V_P$ - VOLTAGE OF PRIMARY WINDING 30

$+V_P$
0
$-V_P$

$V_S$ = VOLTAGE OF SECONDARY WINDING 50

$V_S$ +
0
$V_S$ −

CURRENT SUPPLIED BY CAP 180 VIA TRANSISTOR 110

$C$ +A

CURRENT INTO GATE OF FET 70

0A
−A

CURRENT SUPPLIED BY CAP 190 VIA TRANSISTOR 120